(19) Europäisches Patentamt
European Patent Office
Office européen des brevets

(11) **EP 0 823 642 B1**

(12) **EUROPÄISCHE PATENTSCHRIFT**

(45) Veröffentlichungstag und Bekanntmachung des Hinweises auf die Patenterteilung:
**23.04.2003 Patentblatt 2003/17**

(51) Int Cl.$^7$: **G01R 33/54**

(21) Anmeldenummer: **97202430.1**

(22) Anmeldetag: **04.08.1997**

(54) **MR-Verfahren und Anordnung zur Durchführung des Verfahrens**

MR method and apparatus for carrying out the method

Procédé de RM et appareil pour la mise en oeuvre de la méthode

(84) Benannte Vertragsstaaten:
**DE FR GB NL**

(30) Priorität: **07.08.1996 DE 19631845**

(43) Veröffentlichungstag der Anmeldung:
**11.02.1998 Patentblatt 1998/07**

(73) Patentinhaber:
• **Philips Corporate Intellectual Property GmbH 20099 Hamburg (DE)**
Benannte Vertragsstaaten:
**DE**
• **Koninklijke Philips Electronics N.V. 5621 BA Eindhoven (NL)**
Benannte Vertragsstaaten:
**FR GB NL**

(72) Erfinder:
• **Adelfeld, Bernd, Dr.**
**Röntgenstrasse 24, 22335 Hamburg (DE)**

• **Börnert, Peter, Dr.**
**Röntgenstrasse 24, 22335 Hamburg (DE)**

(74) Vertreter: **Volmer, Georg, Dipl.-Ing. et al**
**Philips Corporate Intellectual Property GmbH, Postfach 50 04 42**
**52088 Aachen (DE)**

(56) Entgegenhaltungen:
**EP-A- 0 216 523       EP-A- 0 228 056**

• **H. BRUDER ET AL.: "Image Reconstruction for Echo Planar Imaging ..." MAGNETIC RESONANCE IN MEDICINE, Bd. 23, 1992, Seiten 311-323, XP000261763**
• **X. ZHOU ET AL.: "Reduction of a New Nyquist Ghost ..." INTERNATIONAL SOCIETY FOR MAGNETIC RESONANCE IN MEDICINE, PROCEEDINGS 4TH MEETING, April 1996, Seite 1477 XP002045743**

**Beschreibung**

Die Erfindung betrifft ein MR-Verfahren, mit wenigstens einer Sequenz, bei der in Anwesenheit eines homogenen, stationären Magnetfeldes die Kernmagnetisierung in einer Schicht eines Untersuchungsbereiches angeregt wird, wonach mindestens ein erstes magnetisches Gradientenfeld mit einem in einer ersten, zur Schicht tangentialen Richtung verlaufenden Gradienten und ggf. ein zweites magnetisches Gradientenfeld mit einem in einer zweiten, zur Schicht ebenfalls tangentialen Richtung verlaufenden Gradienten erzeugt wird und ein MR-Signal (S(t)) aus dem Untersuchungsbereich empfangen wird, wobei zur Erzeugung des ersten bzw des zweiten Gradientenfeldes die Gradientenfelder von wenigstens zwei Gradientenspulenanordnungen kombiniert werden.

Derartige MR-Verfahren sind aus Veröffentlichungen von Zhou et al sowie von Gatehouse et al in ISMRM Abstracts, pp. 386, 1477 bzw. 1481 (1996) bekannt. In diesen Veröffentlichungen ist ein EPI-Verfahren beschrieben, bei dem sowohl der Phasenkodiergradient als auch der Lesegradient schräg zur x- bzw. y-Richtung verläuft, so daß zur Erzeugung dieser Gradienten die Gradientenfelder der Gradientenspulenanordnungen für die x- und die y-Richtung kombiniert werden müssen. Es ist aus diesen Veröffentlichungen weiter bekannt, daß der Phasenkodiergradient bei einer derartigen EPI-Sequenz vom Lesegradienten beeinflußt werden kann, so daß sich sogenannte "Geisterbilder" ergeben können, wenn diese Beeinflussung nicht korrigiert wird. Diese Beeinflussung ergibt sich nur dann, wenn die Kanäle mit den einzelnen Gradientenspulenanordnungen ein unterschiedliches Zeitverhalten haben.

Untersuchungen, die zur Erfindung geführt haben gezeigt, daß die dabei vorgeschlagenen Korrekturmaßnahmen nur begrenzt wirksam sind. Bei der Untersuchung von Schichten, bei denen weder die Schichtnormale noch die erste oder zweite Gradientenrichtung mit einer der Richtungen zusammenfällt, in denen das von jeweils einer der Gradientenspulenanordnungen erzeugte magnetische Gradientenfeld seinen Gradienten hat, können die Geisterbilder gleichwohl auftreten, weil die Phase des MR-Signals durch die Gradientenfelder beeinflußt wird. Diese Phasenverfälschungen können bei phasenempfindlichen MR-Abbildungsverfahren - wie dem EPI-Verfahren - zu störenden Bildartefakten führen.

Aufgabe der vorliegenden Erfindung ist es, ein Verfahren der eingangs genannten Art so auszugestalten, daß die beschriebenen Phasenverfälschungen korrigiert werden können. Diese Aufgabe wird erfindungsgemäß dadurch gelöst, daß aus dem vorgegebenen zeitlichen Verlauf des ersten und/oder des zweiten magnetischen Gradientenfeldes sowie den Impulsantworten der Gradientenspulenanordnungen der zeitliche Verlauf eines in dem MR-Signal enthaltenen Phasenfehlers berechnet wird und daß das MR-Signal entsprechend korrigiert wird. Die Erfindung basiert auf folgenden Überlegungen:

Wenn die Gradientenfelder von zwei (oder drei) Gradientenspulenanordnungen kombiniert werden, die - beispielsweise als Folge von Wirbelstromeffekten - kein identisches Zeitverhalten haben, dann wird während einer Übergangsphase nicht das gewünschte bzw. vorgegebene (erste oder zweite) magnetische Gradientenfeld erzeugt, sondern ein Gradientenfeld, dessen Richtung und ggf. Größe von dem vorgegebenen Gradientenfeld abweichen. Diese temporäre Abweichung des tatsächlichen Gradientenfeldes von dem gewünschten Gradientenfeld läßt sich als Fehlergradientenfeld auffassen, das in eine zur Schicht tangentiale Komponente und eine zur Schicht normale (senkrechte) Komponente zerlegt werden kann.

Die Auswirkungen der zur Schicht tangentialen Komponente und deren Korrektur ist in den eingangs genannten Dokumenten (in Verbindung mit einer EPI-Sequenz) beschrieben. Die Erfindung befaßt sich mit der zur Schicht normalen Komponente und der Korrektur der dadurch bewirkten Effekte.

Durch den zur Schicht normalen, zeitweilig wirksamen Gradienten ergeben sich in dem MR-Signal Phasenfehler, wenn die untersuchte Schicht außerhalb des Isozentrums des MR-Systems liegt (das Isozentrum ist derjenige Punkt im Raum, in dem die von den Gradientenspulenanordnungen erzeugten magnetischen Gradientenfelder den Wert Null haben). Diese Phasenfehler können in dem MR-Bild Artefakte hervorrufen (bei EPI-Sequenzen z.B. Geisterbilder), wenn das MR-Verfahren (einschließlich der Rekonstruktion des MR-Bildes aus den MR-Signalen) phasenempfindlich ist. Die Erfindung vermeidet diese Artefakte dadurch, daß die Phasenfehler im MR-Signal korrigiert werden. Zur Korrektur des Phasenfehlers wird dessen zeitlicher Verlauf aus dem vorgegebenen zeitlichen Verlauf des ersten und/oder des zweiten magnetischen Gradientenfeldes sowie den Impulsantworten der Gradientenspulenanordnungen berechnet.

Die Erfindung ist grundsätzlich bei allen MR-Verfahren anwendbar, bei denen die im MR-Signal enthaltene Phaseninformation für die Rekonstruktion eines MR-Bildes benötigt wird. Dementsprechend sieht eine weitere Ausgestaltung der Erfindung vor, daß der erste Gradient ein Lesegradient mit alternierender Polarität und der zweite Gradient ein Phasenkodiergradient ist, der jeweils nur beim Übergang von der einen Polarität des Lesegradienten zur anderen wirksam ist, wobei die nach dem Polaritätswechsel auftretenden MR-Signale akquiriert und nach Korrektur ihrer Phasenlage zur Erzeugung eines MR-Bildes herangezogen werden. Dabei handelt es sich um das sogenannte EPI-Verfahren, bei dem der Phasenfehler zu Geisterbildern führt, die durch die Erfindung vermieden werden.

Eine andere Ausgestaltung der Erfindung sieht vor, daß die Gradientenfelder von wenigstens zwei Gradientenspulenanordnungen zeitabhängig derart kombiniert werden, daß sich aus der Überlagerung ihrer Gradienten ein rotierender Lesegradient ergibt, dessen Amplitude zeitlich zu- oder abnimmt. Bei dieser Ausgestaltung wird der k-Raum längs einer Spirale abgetastet, wobei die Vorteile der Erfindung besonders zum Tragen kommen, wenn die Spiralen mit einer ungleichförmigen Winkelgeschwindigkeit durchlaufen werden.

Eine weitere Ausgestaltung der Erfindung sieht vor, daß mehrere Sequenzen auf den Untersuchungsbereich einwirken, und daß die Gradientenfelder von wenigstens zwei Gradientenspulenanordnungen kombiniert und von Sequenz zu Sequenz so variiert werden, daß sich die Richtung des daraus resultierenden Lesegradienten von Sequenz zu Sequenz ändert, sein Betrag aber konstant bleibt, und daß die in Verbindung mit dem Lesegradienten auftretenden MR-Signale akquiriert und nach Korrektur ihrer Phasenlage zur Erzeugung eines MR-Bildes herangezogen werden. Dieses als "Projektions-Rekonstruktionsmethode" bekannte MR-Verfahren gestattet zwar auch die Erzeugung von Betragsbildern, bei denen die im MR-Signal enthaltene Phaseninformation keine Rolle spielt, jedoch ist auch eine phasenempfindliche Rekonstruktion möglich, bei der die Erfindung mit Vorteil anwendbar ist.

Ein MR-Gerät zur Durchführung des Verfahrens nach Anspruch 1, das versehen ist mit

a) einem Hauptfeldmagneten zur Erzeugung eines homogenen stationären Magnetfeldes,

b) Gradienten-Spulenanordnungen zur Erzeugung von magnetischen Gradientenfeldern mit in unterschiedlichen Richtungen verlaufenden Gradienten

c) einer Hochfrequenzspulenanordnung zum Anregen der Kernmagnetisierung in einer Schicht eines Untersuchungsbereiches durch wenigstens einen Hochfrequenzimpuls,

d) einem Empfänger zum Erfassen der im Untersuchungsbereich erzeugten MR-Signale,

e) einer Rekonstruktionseinheit zur Rekonstruktion der Kernmagnetisierungsverteilung im Untersuchungsbereich aus den korrigierten MR-Meßdaten

f) einer Steuereinheit zur Steuerung der Gradientenspulenanordnung, der Hochfrequenzspulenanordnung und des Empfängers.

Die Erfindung wird nachstehend anhand von Zeichnungen näher erläutert. Es zeigen:

| Fig. 1 | das Blockschaltbild eines MR-Gerätes, mit dem die Erfindung ausführbar ist, |
| Fig. 2 | den zeitlichen Verlauf verschiedener Signale bei einer Sequenz, bei der die Erfindung mit Vorteil anwendbar ist, |
| Fig. 3a bis 3c | den zeitlichen Verlauf weiterer Signale bei einer solchen Sequenz in vergrößerter Darstellung, |
| Fig. 4a | die Richtungen u, v, w der magnetischen Gradientenfelder in bezug auf ein x, y, z-Koordinatensystem, |
| Fig. 4b | eine Transformationsmatrix zur Umrechnung der beiden Koordinatensysteme ineinander, |
| Fig. 5 | ein Ablaufdiagramm zur Erläuterung der erfindungsgemäßen Signalverarbeitung. |

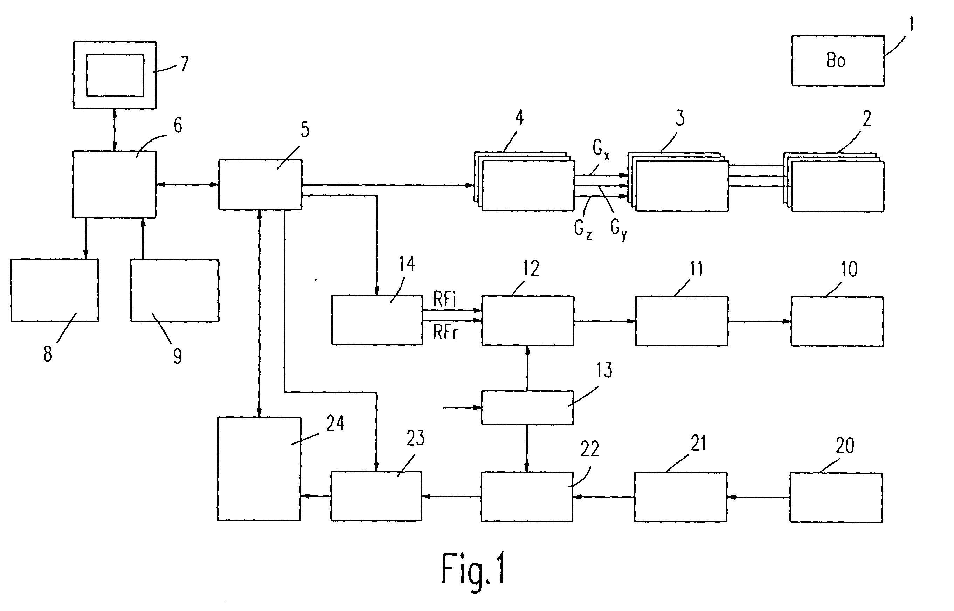

In Fig. 1 is mit 1 ein schematisch dargestellter Hauptfeldmagnet bezeichnet, der in einem nicht näher dargestellten Untersuchungsbereich ein in z-Richtung verlaufendes, stationäres und im wesentlichen homogenes Magnetfeld mit einer Stärke von z.B. 1,5 Tesla erzeugt. Die z-Richtung verläuft dabei horizontal und in Längsrichtung eines nicht näher dargestellten Untersuchungstisches, auf dem sich während einer MR-Untersuchung ein Patient befindet.

Weiterhin ist eine Gradientenspulenanordnung 2 vorgesehen, die drei Spulensysteme umfaßt, mit denen in z-Richtung verlaufende magnetische Gradientenfelder $G_x$, $G_y$ bzw. $G_z$ mit einem Gradienten in x-, y- bzw. z-Richtung erzeugt werden können. Wenn mit dieser Gradientenspulenanordnung Gradientenfelder mit einem Gradienten erzeugt werden sollen, der nicht mit der x-, y- oder z-Richtung zusammenfällt, müssen zwei oder drei der Gradientenspulensysteme gleichzeitig wirksam sein. Der zeitliche Verlauf der magnetischen Gradientenfelder wird von einem Waveform-Generator vorgegeben - und zwar für jede der x-, y- und z-Richtungen gesondert. Der Waveform-Generator 4 wird von einer Rechen- und Steuereinheit 5 gesteuert, die nach Vorgabe des Untersuchungsverfahrens (z.B. eine EPI-Sequenz) und dessen geometrischer Parameter (z.B. Lage der abzubildenden Schicht) den erforderlichen zeitlichen Verlauf der magnetischen Gradientenfelder $G_x$, $G_y$, $G_z$ berechnet und in den Waveform-Generator lädt. Bei einer MR-Untersuchung werden diese Signale aus dem Waveform-Generator ausgelesen und einer Gradientenverstärkeranordnung 3 zugeführt, die daraus die für die Gradientenspulenanordnung 2 erforderlichen Ströme erzeugt.

Die Steuereinheit 5 wirkt außerdem noch mit einer Workstation 6 zusammen. Die Workstation ist mit einem Monitor 7 zur Wiedergabe von MR-Bildern versehen. Über eine Tastatur 8 oder eine interaktive Eingabeeinheit 9, z. B. einen Lichtgriffel, sind Eingaben möglich, wie z.B. die Vorgabe des bei einer MR-Untersuchung anzuwenden MR-Verfahrens, die Lage der abzubildenden Schichten usw.

Die Kernmagnetisierung im Untersuchungsbereich kann durch Hochfrequenzimpulse einer Hochfrequenzspule 10 angeregt werden, die an einen Hochfrequenzverstärker 11 angeschlossen ist, der die Ausgangssignale eines Hochfrequenzsenders 12 verstärkt. In dem Hochfrequenzsender 12 werden die (komplexen) Einhüllenden der Hochfrequenzimpulse mit den von einem Oszillator 13 gelieferten Trägerschwingungen moduliert, deren Frequenz der Larmorfrequenz (bei einem Hauptmagnetfeld von 1,5 Tesla ca. 63 MHz) entspricht. Die (komplexe) Einhüllende wird von der Rechen- und Steuereinheit 5 in einen Generator 14 geladen, der mit dem Sender 12 gekoppelt ist.

Die im Untersuchungsbereich erzeugten MR-Signale werden von einer Empfangsspule 20 aufgenommen und von einem Verstärker 21 verstärkt. Das verstärkte MR-Signal wird in einem Quadraturdemodulator 22 durch zwei um 90° gegeneinander versetzte Trägerschwingungen des Oszillators demoduliert, so daß zwei Signale erzeugt werden, die als Realteil und als Imaginärteil eines komplexen MR-Signals aufgefaßt werden können. Diese Signale werden einem Analog-Digital-Wandler 23 zugeführt, der daraus MR-Daten bildet - falls die Steuereinheit 5 ihn nicht blockiert. Die MR-Daten werden in einer Rekonstruktionseinheit 24 gespeichert und korrigiert, die im Zusammenwirken mit der Workstation 6 aus den von einer Vielzahl von MR-Signalen abgeleiteten MR-Daten MR-Bilder rekonstruiert, die die Kernmagnetisierung im Untersuchungsbereich darstellen.

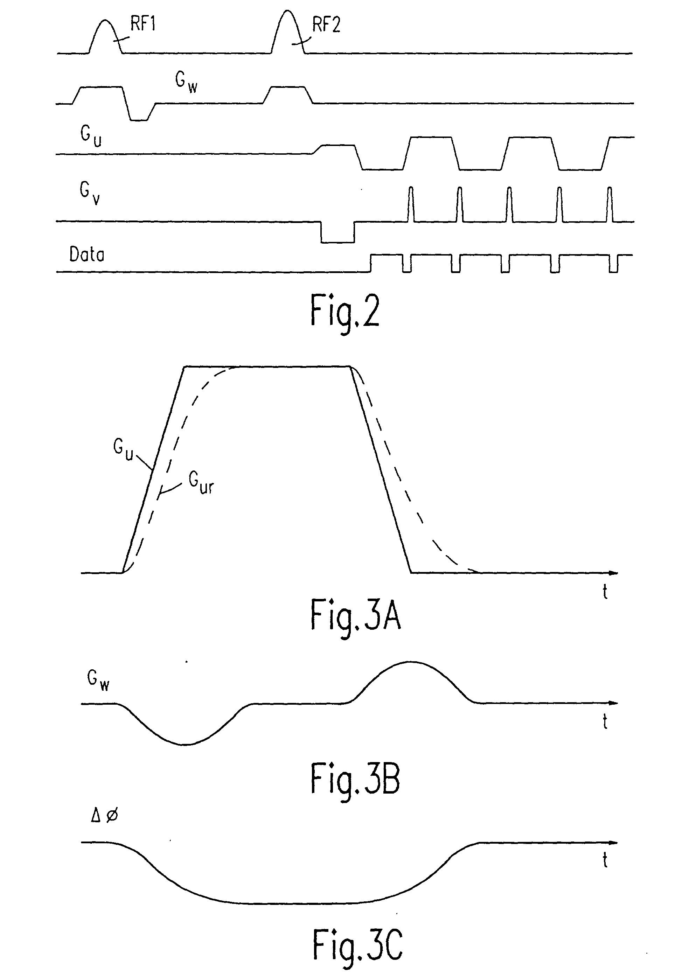

Fig. 2 zeigt eine MR-Sequenz vom EPI-Typ, bei der die Erfindung mit Vorteil anwendbar ist. Die Sequenz umfaßt zwei Hochfrequenz-Anregungsimpulse RF1 und RF2 (1. Zeile), die in Verbindung mit einem in w-Richtung verlaufenden magnetischen Gradientenfeld $G_w$ (2. Zeile) die Kernmagnetisierung in einer zur w-Richtung senkrechten Schicht um 90° bzw. 180° aus ihrer Ruhelage kippen. Danach wird ein alternierender, in u-Richtung verlaufender Lesegradient $G_u$ wirksam (3. Zeile) sowie ein in v-Richtung verlaufender Phasenkodiergradient $G_v$ (4.Zeile), der jeweils nur während der Polaritätswechsel des Lesegradienten $G_u$ wirksam wird. Immer dann, wenn der Lesegradient $G_u$ eine positive oder eine negative Polarität hat, wird ein MR-Signal erfaßt (5. Zeile), d.h. die Rechen- und Steuereinheit 5 gibt dann den Analog-Digital-Wandler 23 frei, so daß die empfangenen MR-Signale in MR-Daten umgesetzt werden können.

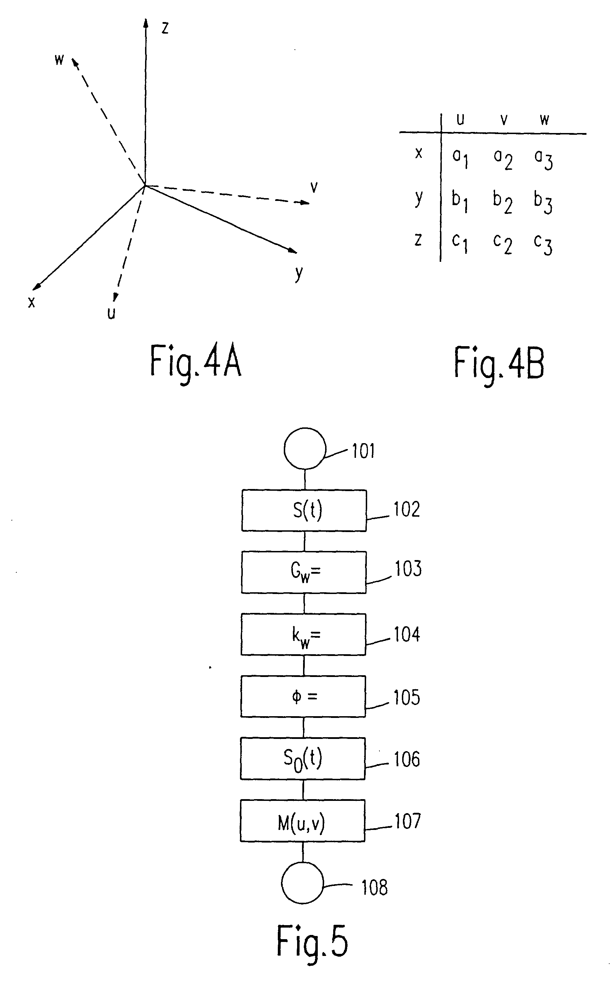

Fig. 4 zeigt die drei zueinander senkrechten Richtungen u, v, w in dem x-, y-, z-Koordinatensystem. Die Richtung u des Lesegradienten und die Richtung v des Phasenkodiergradienten schließen mit der z-Richtung ebenso einen von 90° abweichenden Winkel ein wie die w-Richtung, in der die Normale zu der durch die Impulse RF1 und RF2 angeregten Schicht verläuft. Das bedeutet, daß zur Erzeugung eines der Gradientenfelder $G_u$, $G_v$, $G_w$, die in der Gradientenspulenanordnung 2 enthaltenen Spulensysteme für die x-, die y- und die z-Richtung gleichzeitig wirksam sein müssen. Wie groß die Anteile dabei sein müssen, ergibt sich aus der in Fig. 4b dargestellten Transformationsmatrix.

Aus dieser Transformationsmatrix ist einerseits abzulesen, aus welchen Komponenten sich die Gradienten $G_u$, $G_v$, bzw. $G_w$ zusammensetzen. Danach erhält man beispielsweise ein magnetisches Gradientenfeld $G_u$ mit einer bestimmten Gradientenstärke, wenn die magnetischen Gradientenfelder $G_x$, $G_y$ und $G_z$ mit dem Bruchteil $a_1$, $b_1$ bzw. $c_1$ dieser Gradientenstärke wirksam sind. Andererseits entnimmt man der Transformationsmatrix, wie groß die Gradientenfelder $G_u$, $G_v$ oder $G_w$ sind, wenn nur eines der Gradientenfelder $G_x$, $G_y$ oder $G_z$ wirksam ist (beispielsweise ergeben sich Komponenten des magnetischen Gradientenfeldes in u-, v- und w-Richtung mit der relativen Größe $c_1$, $c_2$, $c_3$, wenn ein magnetisches Gradientenfeld in z-Richtung mit der Größe 1 eingeschaltet wird). Die Elemente $a_1$, $a_2$ und $a_3$ sind dabei jeweils durch den Cosinus des Winkels definiert, den die Achsen u, v, w mit der Achse x einschließen; die Elemente $b_1$, $b_2$, $b_3$ stellen dementsprechend die Richtungscosinusse der Richtung von u, v, w mit der y-Achse dar und $c_1$, $c_2$, $c_3$ den jeweiligen Richtungscosinus zwischen u, v, w einerseits und z andererseits. Die Summe der Quadrate der drei in einer Zeile oder Spalte der Transformationsmatrix enthaltenen Elemente ist bekanntlich 1.

Die in Fig. 2 in den Zeilen 2 bis 4 dargestellten zeitlichen Verläufe von $G_w$, $G_u$, $G_v$ stellen den über die Steuereinheit 5 bzw. den Waveform-Generator 4 vorgegebenen zeitlichen Verlauf dieser Größen dar. Der tatsächliche Verlauf der magnetischen Gradientenfelder weicht aufgrund des Frequenzganges der Komponenten 3, 2 (vergl. Fig. 1) davon ab. Dieser Effekt und die sich daraus ergebenden Konsequenzen werden nachstehend anhand der Figuren 3a, 3b und 3c erläutert. In Fig. 3a ist mit ausgezogenen Linien der zeitliche Verlauf von $G_u$ dargestellt, d.h. der (durch die Steuereinheit 5 bzw. den Waveform-Generator 4) vorgegebene bzw. gewünschte Verlauf des magnetischen Gradientenfeldes in u-Richtung. Mit gestrichelten Linien ist in Fig. 3a der tatsächliche Verlauf $G_{ur}$ des magnetischen Gradientenfeldes dargestellt, der sich ergibt, weil die verschiedenen Gradientensysteme den vorgegebenen zeitlichen Verlauf nicht verzögerungsfrei verfolgen können. Daraus können sich dann Probleme ergeben, wenn sich in den einzelnen Kanälen für x-, y-bzw. z-Richtung unterschiedliche Verzögerungen ergeben.

Wie aus der Transformationsmatrix in Fig. 4b ersichtlich, kann man ein magnetisches Gradientenfeld mit einem in u-Richtung verlaufenden Gradienten nur dann erzeugen, wenn sich die Stärke der magnetischen Gradientenfelder $G_x$, $G_y$, und $G_z$ entsprechend den Elementen $a_1$, $b_1$, $c_1$ der Transformationsmatrix verhält. Diese Bedingung ist nicht erfüllt, solange die von der Gradientenspulenanordnung 2 erzeugten magnetischen Gradientenfelder $G_x$, $G_y$ und $G_z$ nicht ihren vom Waveform-Generator 4 vorgegebenen Wert erreicht haben und sich diesem mit unterschiedlichem zeitlichen Verhalten annähern. In diesen Zeitabschnitten treten daher auch Komponenten des magnetischen Gradientenfeldes auf, die einen Gradienten in v- bzw. w-Richtung haben. Das bedeutet beispielsweise, daß, obwohl zu dem betreffenden Zeitpunkt kein magnetisches Gradientenfeld in w-Richtung vorgegeben wird, der magnetische Gradient $G_u$ von einem solchen Gradienten $G_w$ begleitet wird, der senkrecht zur selektierten Schicht verläuft.

Es läßt sich zeigen, daß für den zeitlichen Verlauf dieses magnetischen Gradientenfeldes $G_w$ (t) die Beziehung gilt

$$G_w(t) = c_3(c_1 G_u(t) + c_2 G_v(t)) * (I_z - I_x) + b_3(b_1 G_u(t) + b_2 G_v(t)) * (I_y - I_x) \tag{1}$$

Dabei sind $c_1...c_3$ und $b_1...b_3$ die Elemente der Transformationsmatrix von Fig. 4b, während $G_u(t)$ und $G_v(t)$ den vorgegebenen (gewünschten) zeitlichen Verlauf des magnetischen Gradientenfeldes in u- bzw. v-Richtung darstellen. Der Operator * symbolisiert eine Faltung (convolution). $I_x$, $I_y$ und $I_z$ sind die Impulsantworten der Kanäle für die x-, y und z-Richtung in den Einheiten 2 und 3.

Die Impulsantwort ist durch den Aufbau der Gradientenspulenanordnung 2 und der Verstärkeranordnung 3 vorgegeben. Sie stellt den zeitlichen Verlauf des magnetischen Gradientenfeldes dar, wenn am Eingang ein sogenannter Dirac-Stoß vorgegeben wird, d.h. ein Signal, das stoßartig auf einen hohen Wert springt und sofort wieder verschwindet. In der Praxis läßt sich ein solcher Dirac-Stoß nicht erzeugen, weil er eine unendliche Amplitude und eine Dauer Null haben müßte. Trotzdem läßt sich die Impulsantwort ermitteln, wenn man den zeitlichen Verlauf einer geeigneten Anregungsgröße am Eingang (Eingangsgröße) eines der Gradientenverstärker 3 und den zeitlichen Verlauf des magnetischen Gradientenfeldes (Ausgangsgröße) mißt, das von der an den Gradientenverstärker angeschlossen Gradientenspule 2 daraufhin erzeugt wird. Wenn man davon ausgeht, daß das System aus Gradientenverstärker 3 und Gradientenspule 2 linear ist (diese Voraussetzung ist in der Praxis erfüllt), dann kann man sich die Tatsache zu Nutze machen, daß die Ausgangsgröße eines linearen Systems durch die Faltung der Eingangsgröße mit der Impulsantwort gegeben ist. Daraus läßt sich die Impulsantwort berechnen, z.B. durch eine "Entfaltung", die die Faltungsoperation rückgängig macht. Die auf diese Weise ermittelte Impulsantworten $I_x$, $I_y$ und $I_z$ für die Kanäle 2,3 für die x-, y- und z-Richtung werden gespeichert.

Aus Gleichung 1 erkennt man, daß beim Anlegen der in der Schichtebene verlaufenden Gradienten $G_u(t)$ und $G_v(t)$ der senkrecht zur Schicht verlaufende Gradient $G_w(t)$ nicht entstehen würde, wenn die drei Kanäle für die x-, y-, z-Richtung identische Impulsantworten $I_x$, $I_y$, $I_z$ hätten. Diese Voraussetzung ist meistens nicht erfüllt. Zwar ergibt sich für die x- und die y-Richtung meist ein identischer zeitlicher Verlauf (so daß der zweite der beiden Summanden in Gleichung (1) verschwindet), jedoch weicht das zeitliche Verhalten der Gradientensysteme 2, 3 für die x- und die y-Richtung von dem zeitlichen Verhalten für die z-Richtung ab. Man erkennt an Gleichung (1) weiter, daß in dem letzteren Fall das zur Schichtebene senkrechte Gradientenfeld auch dann nicht auftritt, wenn $c_3$ gleich Null ist, d.h. wenn die Schichtnormale w senkrecht zur z-Richtung verläuft.

Fig. 3b zeigt den zeitlichen Verlauf des magnetischen Gradientenfeldes $G_w(t)$, das durch den Gradienten $G_u$ gemäß Fig. 3a hervorgerufen wird. Man erkennt, daß der störende Gradient $G_x(t)$ gleichzeitig mit dem tatsächlichen Gradienten in u-Richtung $G_{ur}$ auftritt, und zwar solange dieser von dem vorgegebenen zeitlichen Verlauf $G_u$ abweicht.

Das Auftreten der störenden Komponente $G_w(t)$ bedeutet, daß der sogenannte k-Raum nicht längs einer u-, v-Ebene abgetastet wird, sondern längs einer nicht ebenen Fläche. Für die Komponente $k_w(t)$ im k-Raum gilt dabei

$$k_w(t) = \gamma \int G_w(t)\, dt \tag{2}$$

Dabei ist $\gamma$ die gyromagnetische Konstante (ca 42,5 MHz/T).
Wenn die angeregte Schicht nicht durch das Isozentrum der Gradientenspulenanordnung verläuft, resultiert daraus eine Phasenverschiebung $\Phi(t)$ gemäß der Beziehung

$$\Phi(t) = k_w(t)L \tag{3}$$

wobei L der Abstand der angeregten Schicht von dem Isozentrum ist .

Das bedeutet somit, daß in der angeregten, schrägen und im Abstand vom Isozentrum befindlichen Schicht ein MR-Signal S(t) entsteht, für das die Beziehung gilt

$$S(t) = S_0(t)\, e^{-j\Phi(t)} \tag{4}$$

$S_0(t)$ ist dabei das MR-Signal, das sich ergeben würde, wenn keine Phasenverschiebung durch das störende Gradientenfeld $G_w(t)$ hervorgerufen würde. Fig. 3c zeigt den sich aus den Gleichungen (2) und (3) ergebenden zeitlichen Verlauf des Phasenfehlers $\Phi$. Während des Anstiegs von $G_{ur}$ nimmt der Phasenfehler $\Phi$ auf einen konstanten Wert zu, um beim Abfall von $G_{ur}$ wieder auf den Wert Null abzunehmen.

Ähnliches wie für $G_u$ gilt im Prinzip für $G_v$. Da jedoch Vorder- und Rückflanke bei diesen "blips" unmittelbar aufeinander folgen, ist der Phasenfehler bereits verschwunden, wenn das MR-Signal erfaßt wird (fünfte Zeile von Fig.

2). Bei einer EPI-Sequenz kann daher der auf $G_v$ beruhende Anteil vernachlässigt werden.

Aus den vorstehenden Überlegungen resultiert das anhand von Fig. 5 erläuterte Ablaufdiagramm zur Korrektur des in den empfangenen MR-Daten S(t) enthaltenen Phasenfehlers. Der Block 101 umfaßt die Initialisierung und u.a. die Erzeugung der Hochfrequenzimpulse RF1 und RF2. Danach wird bei der positiven und der negativen Polarität des Lesegradienten $G_u$ jeweils ein MR-Signal erfaßt und in eine Folge von MR-Daten umgesetzt (Block 102). Im Block 103 wird gemäß Gleichung (1) der zeitliche Verlauf des zur Schichtebene senkrechten magnetischen Gradientenfeldes $G_w(t)$ berechnet. Aus dem berechneten Wert wird im Block 104 der daraus gemäß Gleichung (2) resultierende Wert $k_w(t)$ berechnet, womit im Block 105 der Wert für den Phasenfehler $\Phi$ gemäß Gleichung (3) berechnet werden kann. Im Block 106 wird der gemessene zeitliche Verlauf des Signals S(t) entsprechend dem berechneten zeitlichen Verlauf korrigiert, indem der berechnete Phasenfehler und die Signalphase, die sich aus dem zeitlichen Verlauf des gemessenen MR-Signals S(t) ergibt, zueinander addiert werden. Resultat ist entsprechend Gleichung (4) das MR-Signal $S_0(t)$, das von dem Phasenfehler befreit ist.

Die Rechenschritte 103 und 105 greifen auf Werte zurück ($a_1...c_3$; $G_u(t)...$; $I_x...I_z$), die schon bei Beginn der MR-Untersuchung bekannt sind. Diese Berechnung kann daher bereits erfolgen, bevor das MR-Signal erfaßt wird (Block 102), so daß das MR-Signal unmittelbar nach seiner Messung korrigiert werden kann.

Im Block 107 wird die Kernmagnetisierungsverteilung M(u,v) innerhalb der angeregten Schicht aus den korrigierten MR-Signalen $S_0(t)$ rekonstruiert. Dabei muß berücksichtigt werden, daß der gleiche Effekt, der im zeitlichen Zusammenhang mit dem Lesegradienten $G_u(t)$ den störenden Gradienten $G_w(t)$ entstehen läßt, auch ein unerwünschtes magnetisches Gradientenfeld in v-Richtung erzeugt, durch das die Phasenkodierung verfälscht wird. Man kann dieser Verfälschung Rechnung tragen, indem man die "blips" des Gradienten $G_v$ entsprechend vergrößert oder verkleinert, wie in den eingangs genannten Veröffentlichungen erläutert, oder indem man ein Rekonstruktionsverfahren anwendet, das keine gleichmäßige Verteilung der MR-Daten im k-Raum voraussetzt, wie z.B. das bekannte Gridding-Verfahren. - Im Block 108 endet das Verfahren.

Vorstehend wurde die Erfindung in Verbindung mit einer EPI-Sequenz erläutert. Die Erfindung ist jedoch auch bei anderen MR-Verfahren anwendbar, bei denen die Bildinformation phasenempfindlich aus den MR-Daten abgeleitet wird. Die mit den unerwünschten Gradienten $G_w(t)$ einhergehenden Artefakte (Geisterbilder, Unschärfe usw.) hängen dabei von dem jeweiligen MR-Verfahren ab.

**Patentansprüche**

1. MR-Verfahren, mit wenigstens einer Sequenz, bei der in Anwesenheit eines homogenen, stationären Magnetfeldes die Kernmagnetisierung in einer Schicht eines Untersuchungsbereiches angeregt wird, wonach mindestens ein erstes magnetisches Gradientenfeld ($G_u$) mit einem in einer ersten, zur Schicht tangentialen Richtung (u) verlaufenden Gradienten und ggf. ein zweites magnetisches Gradientenfeld ($G_v$) mit einem in einer zweiten, zur Schicht ebenfalls tangentialen Richtung (v) verlaufenden Gradienten erzeugt wird und ein MR-Signal (S(t)) aus dem Untersuchungsbereich empfangen wird, wobei zur Erzeugung des ersten bzw des zweiten Gradientenfeldes die Gradientenfelder ($G_x$, $G_y$, $G_z$) von wenigstens zwei Gradientenspulenanordnungen kombiniert werden, **dadurch gekennzeichnet, daß** aus dem vorgegebenen zeitlichen Verlauf des ersten und/oder des zweiten magnetischen Gradientenfeldes ($G_u$, $G_v$) sowie den Impulsantworten ($I_x$, $I_y$, $I_z$) der Gradientenspulenanordnungen der zeitliche Verlauf eines in dem MR-Signal enthaltenen Phasenfehlers ($\Phi$) berechnet wird und daß das MR-Signal (S(t)) entsprechend korrigiert wird.

2. MR-Verfahren nach Anspruch 1, **dadurch gekennzeichnet, daß** der erste Gradient ($G_u$) ein Lesegradient mit alternierender Polarität und der zweite Gradient ($G_v$) ein Phasenkodiergradient ist, der jeweils nur beim Übergang von der einen Polarität des Lesegradienten zur anderen wirksam ist, wobei die nach dem Polaritätswechsel auftretenden MR-Signale akquiriert und nach Korrektur ihrer Phasenlage zur Erzeugung eines MR-Bildes herangezogen werden.

3. MR-Verfahren nach Anspruch 1, **dadurch gekennzeichnet, daß** die Gradientenfelder ($G_x$, $G_y$, $G_z$) von wenigstens zwei Gradientenspulenanordnungen zeitabhängig derart kombiniert werden, daß sich aus der Überlagerung ihrer Gradienten ein rotierender Lesegradient ($G_u$) ergibt, dessen Amplitude zeitlich zu- oder abnimmt.

4. MR-Verfahren nach Anspruch 1, **dadurch gekennzeichnet, daß** in jeder Sequenz in Anwesenheit eines homogenen, stationären Magnetfeldes die Kernmagnetisierung in einer Schicht des Untersuchungsbereiches angeregt wird, wonach in Anwesenheit eines Lesegradienten ($G_u$) die Akquisition eines MR-Signals erfolgt, wobei der Lesegradient durch Kombination der

Gradientenfelder ($G_x$, $G_y$, $G_z$) von wenigstens zwei Gradientenspulenanordnungen erzeugt wird, die von Sequenz zu Sequenz so variiert werden, daß sich die Richtung des daraus resultierenden Lesegradienten von Sequenz zu Sequenz ändert, sein Betrag aber konstant bleibt, und daß die in Verbindung mit dem Lesegradienten auftretenden MR-Signale (S(t)) akquiriert und nach Korrektur ihrer Phasenlage zur Erzeugung eines MR-Bildes herangezogen werden.

5. MR-Gerät zur Durchführung des Verfahrens nach Anspruch 1, mit

    a) einem Hauptfeldmagneten (1) zur Erzeugung eines homogenen stationären Magnetfeldes,

    b) Gradienten-Spulenanordnungen (2...4) zur Erzeugung von magnetischen Gradientenfeldern mit in unterschiedlichen Richtungen verlaufenden Gradienten

    c) einer Hochfrequenzspulenanordnung (10) zum Anregen der Kernmagnetisierung in einer Schicht eines Untersuchungsbereiches durch wenigstens einen Hochfrequenzimpuls (RF) in Verbindung mit einem magnetischen Gradientenfeld

    d) einem Empfänger (9) zum Erfassen der im Untersuchungsbereich erzeugten MR-Signale,

    e) einer Rekonstruktionseinheit (24) zur Rekonstruktion der Kernmagnetisierungsverteilung im Untersuchungsbereich aus den korrigierten MR-Meßdaten

    f) einer Steuereinheit (5) zur Steuerung der Gradientenspulenanordnung (2...4), der Hochfrequenzspulenanordnung (10) und des Empfängers (21, 22)

**dadurch gekennzeichnet, daß** die Steuereinheit (5) so programmiert ist, daß wenigstens zwei der Gradientenspulenanordnungen gleichzeitig ein magnetisches Gradientenfeld ($G_u$,$G_v$) mit von der Steuereinheit vorgegebenem zeitlichen Verlauf erzeugen, und daß Mittel zur Berechnung des zeitlichen Verlaufs eines in dem MR-Signal enthaltenen Phasenfehlers ($\Phi$) vorgesehen sind, die den Phasenfehler ($\Phi$) aus dem vorgegebenen zeitlichen Verlauf des magnetischen Gradientenfeldes sowie den Impulsantworten ($I_x$, $I_y$, $I_z$) der Gradientenspulenanordnungen berechnen und das MR-Signal (S(t)) entsprechend korrigieren.

**Claims**

1. An MR method which involves at least one sequence in which the nuclear magnetization in a slice of an examination zone is excited in the presence of a uniform, steady magnetic field, after which at least one first magnetic gradient field ($G_u$) is generated which has a gradient extending in a first direction (u) which is tangential to the slice, and possibly also a second magnetic gradient field ($G_v$) with a gradient extending in a second direction (v) which is also tangential to the slice, an MR signal (S(t)) being received from the examination zone and the gradient fields ($G_x$, $G_y$, $G_z$) of at least two gradient coil systems being combined in order to generate the first and the second gradient field,
**characterized in that** the temporal variation of a phase error ($\Phi$) contained in the MR signal is calculated from the imposed temporal variation of the first and/or the second magnetic gradient field ($G_u$, $G_v$) as well as from the pulse responses ($I_x$, $I_y$, $I_z$) of the gradient coil systems, and that the MR signal (S(t)) is corrected accordingly.

2. An MR method as claimed in Claim 1, **characterized in that** the first gradient ($G_u$) is a read gradient having an alternating polarity and the second gradient ($G_v$) is a phase encoding gradient which is active exclusively upon the transitions from one polarity of the read gradient to the other, the MR signals occurring after the polarity reversal being acquired and used, after correction of their phase position, for the formation of an MR image.

3. An MR method as claimed in Claim 1, **characterized in that** the gradient fields ($G_x$, $G_y$, $G_z$) of at least two gradient coil systems are combined in such a time-dependent manner that the superposition of their gradients yields a rotating read gradient ($G_u$) whose amplitude increases or decreases as a function of time.

4. An MR method as claimed in Claim 1, **characterized in that** in each sequence the nuclear magnetisation is excited in a slice of the examination zone in the presence of a uniform, steady magnetic field, after which the acquisition of an MR signal takes place in the presence of a read gradient (Gu), the read gradient being formed by combining the gradient fields ($G_x$, $G_y$, $G_z$) of at least two gradient coil systems which are varied from one sequence to another in such a manner that the direction of the read gradient resulting therefrom varies from one sequence to another whereas its absolute value remains constant, and that the MR signals (S(t)) occurring in conjunction with the read gradient are acquired and used, after correction of their phase position, for the formation of an MR image.

**5.** An MR apparatus for carrying out the method as claimed in Claim 1, including

a) a main field magnet (1) for generating a uniform, steady magnetic field,
b) gradient coil systems (2 ... 4) for generating magnetic gradient fields having gradients extending in different directions,
c) an RF coil system (10) for exciting the nuclear magnetization in a slice of an examination zone by means of at least one RF pulse (RF) in conjunction with a magnetic gradient field,
d) a receiver (9) for acquiring the MR signals generated in the examination zone,
e) a reconstruction unit (24) for reconstructing the nuclear magnetization distribution in the examination zone from the corrected MR measuring data,
f) a control unit (5) for controlling the gradient coil systems (2 ... 4), the RF coil system (10) and the receiver (21, 22),

**characterized in that** the control unit (5) is programmed so that at least two of the gradient coil systems simultaneously generate a magnetic gradient field ($G_u$, $G_v$) with a temporal variation which is imposed by the control unit, and that there are provided means for calculating the temporal variation of a phase error ($\Phi$) contained in the MR signal, which means calculate the phase error ($\Phi$) from the imposed temporal variation of the magnetic gradient field as well as from the pulse responses ($I_x$, $I_y$, $I_z$) of the gradient coil systems and correct the MR signal (S(t)) accordingly.

**Revendications**

**1.** Procédé R.M.N. avec au moins une séquence, la magnétisation nucléaire étant excitée dans une couche d'un champ d'examen en présence d'un champ magnétique stationnaire homogène, après quoi un premier champ à gradient magnétique ($G_u$) avec un gradient s'étendant dans une première direction (u) tangentielle à la coupe et éventuellement un deuxième champ à gradient ($G_v$) magnétique avec un gradient s'étendant dans une deuxième direction (v) également tangentielle à la coupe et un signal R.M.N. (S(t)) est reçu de la champ d'examen, les champs à gradient ($G_x$, $G_y$, $G_z$) d'au moins deux montages de bobines à gradient étant combinées pour la production des premier ou deuxième champs à gradient,
**caractérisé en ce que** le tracé temporel d'une erreur de phase ($\Phi$) contenue dans le signal R.M.N. est calculé à partir du tracé temporel préalablement déterminé des premier et/ou deuxième champs à gradient magnétique ($G_u$, $G_v$) ainsi que des réponses d'impulsion ($I_x$, $I_y$, $I_z$) des montages de bobines à gradient et que le signal R.M.N. (S(t)) est corrigé en conséquence.

**2.** Procédé R.M.N. selon la revendication 1,
**caractérisé en ce que** le premier gradient ($G_u$) est un gradient de lecture avec une polarité alternée et le deuxième gradient ($G_v$) est un gradient à codage de phase qui n'est respectivement actif qu'en cas de transition d'une des polarités du gradient de lecture à l'autre, les signaux R.M.N. présents après le changement de polarité étant acquis et utilisés après correction de leur position de phase pour la production d'une image R.M.N.

**3.** Procédé R.M.N. selon la revendication 1,
**caractérisé en ce que** les champs à gradient ($G_x$, $G_y$, $G_z$) d'au moins deux montages de bobines à gradient sont combinés en fonction du temps de telle sorte qu'il résulte de la superposition de leurs gradients un gradient de lecture ($G_u$) à rotation dont l'amplitude augmente ou diminue avec le temps.

**4.** Procédé R.M.N. selon la revendication 1,
**caractérisé en ce que**, dans chaque séquence, la magnétisation nucléaire est excitée en présence d'un champ magnétique stationnaire homogène dans une couche du champ d'examen, après quoi, en présence d'un gradient de lecture ($G_u$), il se produit l'acquisition d'un signal R.M.N., le gradient de lecture étant produit par combinaison des champs à gradient ($G_x$, $G_y$, $G_z$) d'au moins deux montages de bobines à gradient qui varient d'une séquence à l'autre de telle sorte que la direction du gradient de lecture en résultant varie d'une séquence à l'autre tandis que sa valeur reste constante et que les signaux R.M.N. (S(t)) présents en relation avec le gradient de lecture soient acquis et utilisés après correction de leur position de phase pour la production d'une image R.M.N.

**5.** Appareil R.M.N. de mise en oeuvre du procédé selon la revendication 1, avec:

a) un aimant de champ principal (1) pour la production d'un champ magnétique stationnaire homogène;

b) des montages de bobines à gradient (2,...,4) pour la production de champs à gradient magnétique avec des gradients s'étendant dans différentes directions;

c) un montage de bobines à haute fréquence (10) pour l'excitation de la magnétisation nucléaire dans une couche d'un champ d'examen par au moins une impulsion à haute fréquence (RF) en association avec un champ à gradient magnétique;

d) un récepteur (9) pour la saisie des signaux R.M.N. produits dans la champ d'examen,

e) une unité de reconstruction (24) pour la reconstruction de la distribution de la magnétisation nucléaire dans le champ d'examen à partir des données de mesure R.M.N. corrigées;

f) une unité de commande (5) pour la commande du montage de bobines à gradient (2, ..., 4), du montage de bobines à haute fréquence (10) et du récepteur (21, 22),

**caractérisé en ce que** l'unité de commande (5) est programmée de telle sorte qu'au moins deux des montages de bobines à gradient produisent simultanément un champ à gradient magnétique ($G_u$, $G_v$) avec un tracé temporel préalablement déterminé par l'unité de commande et que des moyens sont prévus pour le calcul du tracé temporel d'une erreur de phase ($\Phi$) contenue dans le signal R.M.N. et calculent l'erreur de phase ($\Phi$) à partir du tracé temporel préalablement déterminé du champ à gradient magnétique ainsi que les réponses d'impulsion ($I_x$, $I_y$, $I_z$) des montages de bobines à gradient et corrigent le signal R.M.N. ($S(t)$) en conséquence.

Fig.1

Fig.2

Fig.3A

Fig.3B

Fig.3C

Fig.4A

Fig.4B

| | u | v | w |
|---|---|---|---|
| x | $a_1$ | $a_2$ | $a_3$ |
| y | $b_1$ | $b_2$ | $b_3$ |
| z | $c_1$ | $c_2$ | $c_3$ |

○ — 101

| $S(t)$ | — 102 |
|---|---|
| $G_w=$ | — 103 |
| $k_w=$ | — 104 |
| $\phi =$ | — 105 |
| $S_0(t)$ | — 106 |
| $M(u,v)$ | — 107 |

○ — 108

Fig.5